# EUROPEAN PATENT APPLICATION

(11) **EP 1 137 058 A1**
(43) Date of publication of application: **26.09.2001**
(21) Application number: 00106287.6
(22) Date of filing: 23.03.2000
(51) Int. Cl.: H01L 21/3213

(54) **A method for pattering layers of semiconductor devices**

(71) Applicant: MOTOROLA, INC., Schaumburg, IL 60196 (US); Semiconductor 300 GmbH & Co. KG, 01099 Dresden (DE); Infineon Technologies AG, 81541 München (DE)
(72) Inventor: Grewal, Virinder, 85560 Ebersberg (DE); McGowan, Ricky, 01309 Dresden (DE); Paschedag, Lars, 01109 Dresden (DE); Zeindl, Hans P., 01129 Dresden (DE); Schneider, Steffan, 08262 Rautenkranz (DE)
(74) Representative: Richardt, Markus Albert

(57) **Abstract**

The invention relates to a method for patterning layers of semiconductor devices.

The invention comprises the steps of:
- opening a hard mask (2, 3) in situ in a metal-etch chamber of a metal-etch tool, and
- performing a metal etch in the metal-etch chamber.

## Description

### Field of the Invention

The present invention generally relates to the production or fabrication of semiconductor devices and more particularly to a method for patterning layers of semiconductor devices which is performed during the production of semiconductor devices.

### Background of the Invention

In the mass production of semiconductor devices like, e.g. memory chips, it is known to use photomasks or masks and etching processes to pattern layers of the chip, i.e. or metal-1-layer of the chip.

To etch metal layers and especially aluminium stacks not only patterns of photoresist are used, but also a hard mask. A hard mask normally comprises one or several layers consisting of oxidized silicon, e.g. SiO₂ or SiON. The hard mask is used because of the better selectivity of the etching towards the latter compared to the resist mask and because stacks of metallic layers sometimes are needed which are thicker, and the etching of such stack could also lead to a complete etching of the resist mask.

In known methods for patterning parts of semiconductor devices the hard mask is opened using a plasma etching in an oxide-etch tool. There may be additional dry resist ash and wet dip before the succeeding metal etch. In the next step the metallic layers are patterned in the plasma etch in a metal-etch chamber of a metal-etch tool. Then, a passivation and a resist strip is performed in a strip chamber of the metal-etch tool. At last, the polymers are removed by wet cleaning in a wet bench or spray tool.

This leads to a time consuming method for the opening of the hard mask and the complete metal etch, i.e. the metal etch together with the resist strip, the passivation and the polymer removal, because a lot of steps are used which are performed in different chambers of the processing line or production line. Moreover, if in the processing line the oxide-etch tool is overloaded more oxide-etch chambers have to be used, although there still exists a capacity in the metal-etch tool.

Thus, it is an object of the present invention to overcome these deficiencies and to provide a method for patterning layers of semiconductor devices and especially metal layers, which is a part of a method for the production of semiconductor devices which needs few processing time and which saves chambers in the processing line.

### Brief Description of the Drawings

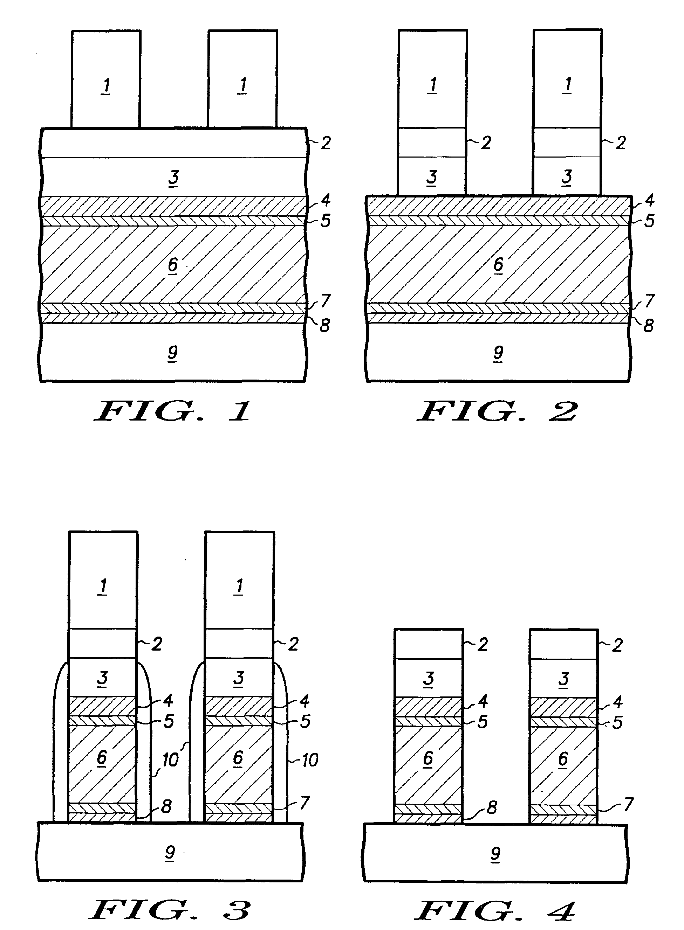

Fig. 1 to 4 illustrate enlarged, cross-sectional views of the production steps of the in situ hard mask open and the metal etch for the metal-1-layer of a 64 Mbit chip.

### Detailed Description of the Preferred Embodiment

Fig. 1 illustrates an enlarged, cross-sectional view of an embodiment of the present invention in a beginning stage of fabrication of the metal layer. It is shown an already structured resist 1 which is especially developed a photoresist mask. The photoresist is on top of a Plasma-Enhanced-Anti-Reflection-Layer (PEARL) which comprises SiON. Under the PEARL layer there is an Undoped-Spin-Glass-layer (USG) which comprises SiO₂. These two layers, the PEARL-layer and the USG-layer, are the layers of which the hard mask is made in this embodiment. Underneath the hard mask the metal layer which is a stack of metal layers in this preferred embodiment is shown. The stack of metal layers consists of a layer of TiN 4 above the layer of Ti 5 which is above a layer of AlCu 6 which is above a layer of TiN 7 which itself is above a layer of Ti 8. The AlCu-layer 6 consists of 0.5 % copper. Underneath the metal layer there is arranged a layer of silicon dioxide (SiO₂) 9.

In a first step the hard mask is etched or opened in situ in a metal-etch chamber. This is shown in Fig. 2 which illustrates the structure of Fig. 1 further along in processing. A plasma chemistry is used for opening or etching the hard mask. The plasma chemistry comprises CHF₃ and/or CF₄, together with or without Cl₂ or N₂. After opening of the hard mask the sidewalls of the hard mask 2 and 3 should be free of polymers for good profile control during the succeeding metal etch step.

Fig. 3 illustrates the structure of Fig. 2 further along in processing. A metal etch is performed to remove parts of the metal layer which in this preferred embodiment are 5 metal layers 3 to 8 as mentioned above. The metal layers are etched using a plasma chemistry BCl₃, Cl₂ or N₂ or a mixture of this chemistry.

The sidewall polymers 10 which were produced during the metal etch is then removed in situ in the same metal-etch chamber by using a N₂-plasma. If the resist 1 is not that thick it could also be removed in this step which would directly lead to the structure of Fig. 4.

If the resist 1 is too thick for an effective removal in the previous mentioned step the wafer is transported into a strip chamber of the metal-etch tool and there the resist 1 is removed and the metal layer 4 to 8 is passivated towards corrosion by using a plasma chemistry comprising H₂O, O₂ or N₂ or a mixture of this chemistry. It is preferred that the passivation of the metal takes place prior to the removal of the resist 1.

Fig. 4 illustrates the structure of Fig. 3 after removing the resist 1 and the passivation. Between the processing steps it is preferred to evacuate the processing chamber if different chemistry is used.

In a preferred embodiment of the invention, the process parameters of the process steps in an applied material (AMAT) decoupled plasma source (DPS) metal-etch chamber, which is typically a high-density plasma (HDP) etch-chamber, in which inductive power excitation is used, the ranges of the parameters for the hard-mask open are as following:
- Step_He_Setpoint: 7000-13000mT
- RF Source_Power: 1500-2500W
- RF_Bias_Power: 200-400W
- Pressure: 5-20mT
- Gas_CF4: 50-150sccm
- Gas_C12: 30-70sccm

Whereas sccm are standard cubic cm/min and step_He_Setpoint is the backside pressure of helium, whereas helium is transported between the wafer and the lower electrode to receive a better heat conduction; the RF_Source_Power is the radio frequency power which is inductively excited over a coil in the upper area of the chamber, whereas the plasma is ignited over this RF_Power; RF_Bias_Power means the power which is coupled capacitively by use of the lower electrode on which the wafer is supported, to the wafer. This leads to a negative charging of the wafer and to the aligned acceleration of positive charged ions to the wafer. which is necessary for unisotropic etching. Further, Gas_CF4 means the amount of CF₄ which is used and Gas_Cl2 means the amount of Cl₂ which is used. Pressure means the pressure during processing in mTorr.

In a preferred embodiment, the parameters are as following:
- Step_He_Setpoint: 10000mT
- RF_Source Power: 2000W
- RF_Bias Power: 300W
- Pressure: 8mT
- Gas_CF4: 100sccm
- Gas_Cl2: 50sccm

Typical parameters for the metal-etch step are as following:
- Step_He_Setpoint 7000-13000mT
- RF_Source Power 1000-2000W
- RF Bias_Power 200-400W
- Pressure 5-15mT
- Gas_C12 100-200sccm
- Gas_BCl3 20-100sccm
- Gas_N2 0-50sccm

In a preferred embodiment of the invention, the parameters for the metal-etch step are as following:
- Step_He_Setpoint 10000mT
- RF_Source_Power 2000W
- RF_Bias_Power 300W
- Pressure 8mT
- Gas_Cl2 130sccm
- Gas_BCl3 70sccm
- Gas N2 25sccm

The present invention provides a method for patterning layers of semiconductor devices. The method comprises the steps of
- opening a hard mask in a metal-etch chamber of a metal-etch tool, and
- performing a metal etch in the metal-etch chamber.

Compared to the state of the art methods this method shows a big advantage, because the opening of the hard mask is performed in situ in a metal-etch chamber and not in the oxide-etch tool or an oxide chamber. Thus, the semiconductor material or the wafer which is treated does not need to be transported from an oxide-etch chamber of the oxide-etch tool to a metal-etch chamber of the metal-etch tool. Further other processes in between do not necessarily have to be performed. This leads to a shorter overall processing time and a processing line which does not need that much oxide-etch chambers. Moreover, the utilisation of capacity of the processing line and especially the metal-etch tool is improved with this method especially metal layers, e.g. Ti/AlCu/TiN-stacks, are patterned. The hard mask comprises especially SiO2 and SiON.

Preferably, the opening of the hard mask is performed with a plasma chemistry comprising CHF₃ and/or CF₄ with or without Cl₂ or N₂ as additives. The opening of the hard mask is especially performed via an reactive ion etch (RIE).

The fluorine is etching the silicon oxide (SiO₂, SiON) whereas additives like Cl₂ or N₂ may be used to reduce etchrate microloading and/or profile control.

Preferably, the sidewalls of the hard mask are free of polymers after the etching of the hard mask.

Preferably, the metal etch is then performed with a plasma chemistry comprising BCl₃, Cl₂ or N₂ or a mixture of said chemistry. This is especially performed via RIE.

Preferably, a plasma is used to perform the opening of the hard mask or the etching of the metal or the metal layers. By using a plasma the nitrogen leads to a better dissociation of the molecules into radicals. The nitrogen also leads to polymerisation into organical carbon chains which comprises the elements N and Cl.

Preferably, the method further comprises the step of removing the sidewall polymers in the metal-etch chamber. These polymers build up during metal etch and are preferably used for anisotropic etching. This step has the advantage that the wafer does not have to be transported into another chamber especially via RIE. The removal of the sidewall polymers is thus performed in situ in the metal-etch chamber. Preferably a plasma of nitrogen (N₂) is used for the removal of the sidewall polymers. If all passivation polymers are removed in this step the following wet cleaning can be omitted. This saves work in the process flow and omits problems imposed by wet clean, e.g. electro-corrosion. If not all polymers have been removed in the previous step, the method preferably further comprises the steps of passivating the metal and removing the residual resist mask in a strip chamber of the metal-etch tool after the removal of the sidewall polymers. Preferably, a plasma chemistry of H₂O, O₂ or N₂ or a mixture or said chemistry is used.

The above-mentioned problem is also solved by a method for patterning layers of semiconductor devices, comprising the steps of
- opening a hard mask in a metal-etch chamber of a metal-etch tool,
- performing a metal etch in the metal-etch chamber,
- removing sidewall polymers in the metal-etch chamber

Preferably the method further comprises the step of
- removing a resist, which is positioned on the hard mask, during the step of the removing of the sidewall polymers in the metal-etch chamber.

However, this method is preferably used if the resist is rather thin.

The problem is also solved by a method for patterning layers of semiconductor devices, comprising the steps of
- opening a hard mask in a metal-etch chamber of a metal-etch tool,
- performing a metal etch in the metal-etch chamber,
- removing sidewall polymers in the metal-etch chamber, and
- passivating the metal and removing residual resist, which is positioned on the hard mask, in a resist strip chamber of the metal-etch tool.

Preferably, the methods according to the invention are performed in a 300 mm- (diameter of wafers) process technology of the production of semiconductor devices. It is, however, not restricted to 300 mm-process technology.

It should now be apparent for a person skilled in the art that there is provided a method for patterning layers and especially metal layers of semiconductor devices with which the opening of a hard mask and a metal etch is performed without using an extensive amount of different processing chambers and which lead to a comparably fast processing.

While there have been described herein the principle of the invention it is to be clearly understood to those skilled in the art that this description is made only by way of example and not as limitation to the scope of the invention. E.g. the method for patterning parts of semiconductor devices may equally well be applied to the manufacture of other semiconductor products and devices such as 256 Mbit-chips or chips which do not belong to the silicon technology but to e.g. the gallium arsenide technology or devices or germanium technology or devices or semiconducting technology or devices. Accordingly it is intended by the appended claims to cover all such modifications of the invention which fall within the true spirit and scope of the invention.

### List of reference numerals

- 1: photoresist
- 2: PEARL (SiON)
- 3: Undoped Spin Glas (USG)
- 4: TiN
- 5: Ti
- 6: AlCu (0.5 %)
- 7: TiN
- 8: Ti
- 9: SiO₂
- 10: sidewall polymer

## Claims

1. A method for patterning layers of semiconductor devices, comprising the steps of
- opening a hard mask (2, 3) in a metal-etch chamber of a metal-etch tool, and
- performing a metal etch in the metal-etch chamber.

2. The method of claim 1, wherein the opening of the hard mask (2, 3) is performed with a chemistry comprising CHF₃ and/or CF₄, with or without Cl₂ or N₂ as additives.

3. The method of claim 1, wherein the metal etch is performed with a chemistry comprising BCl₃, Cl₃ or N₂ or a mixture of said chemistry.

4. A method according to the claims 2 or 3, wherein a plasma is used to perform the opening or the etching.

5. The method according to one of the claims 1 to 4, wherein the method further comprises the step of removing the sidewall polymers (10) in the metal-etch chamber.

6. The method of claim 5 or 6, wherein a plasma of N₂ is used for the removal of the sidewall polymers (10).

7. The method of claim 5, wherein the method further comprises the steps of passivating the metal (4, 5, 6, 7, 8) and removing a resist (1) in a strip chamber of the metal-etch tool after the removal of the sidewall polymers (10).

8. The method of claim 7, wherein a plasma chemistry of H₂O, O₂, or N₂ or a mixture of said chemistry is used.

9. A method for patterning layers of semiconductor devices, comprising the steps of
- opening a hard mask (2, 3) in a metal-etch chamber of a metal-etch tool,
- performing a metal etch in the metal-etch chamber.

10. A method according to claim 9, werein the method further comprises the step of
- removing sidewall polymers (10) in the metal-etch chamber, and
- removing a resist (1), which is positioned on the hard mask (2, 3), during the step of the removing of the sidewall polymers (10) in the metal-etch chamber.

11. A method for patterning layers of semiconductor devices, comprising the steps of
- opening a hard mask (2, 3) in a metal-etch chamber of a metal-etch tool,
- performing a metal etch in the metal-etch chamber,
- removing sidewall polymers (10) in the metal-etch chamber, and
- passivating the metal (4, 5, 6, 7, 8) and removing a resist (1), which is positioned on the hard mask (2, 3), in a strip chamber of the metal-etch tool.
